# EUROPÄISCHE PATENTSCHRIFT

(11) **EP 3 325 918 B1**
(45) Veröffentlichungstag und Bekanntmachung des Hinweises auf die Patenterteilung: **18.09.2019**
(21) Anmeldenummer: 16725121.4
(22) Anmeldetag: 24.05.2016
(51) Int. Cl.: G01C 19/5747

(54) **DREHRATENSENSOR MIT MINIMIERTEN STÖRBEWEGUNGEN IN DER ANTRIEBSMODE**
ROTATIONAL SPEED SENSOR WITH MINIMISED INTERFERENCE MOVEMENTS IN THE DRIVING MODE
CAPTEUR DE LACET À MOUVEMENTS PERTURBATEURS MINIMISÉS EN MODE D'ENTRAÎNEMENT

(30) Priorität: 17.07.2015 DE 102015213447
(43) Veröffentlichungstag der Anmeldung: 30.05.2018
(73) Patentinhaber: Robert Bosch GmbH, 70442 Stuttgart (DE)
(72) Erfinder: LASSL, Andreas, 71254 Ditzingen (DE); KUHLMANN, Burkhard, 72762 Reutlingen (DE); HATTASS, Mirko, 70191 Stuttgart (DE); HOEPPNER, Christian, 70197 Stuttgart (DE); SCHMIDT, Benjamin, 70499 Stuttgart (DE); BALSLINK, Thorsten, 72138 Kirchentellinsfurt (DE)
(86) Internationale Anmeldenummer: PCT/EP2016/061717
(87) Internationale Veröffentlichungsnummer: WO 2017/012748

(56) Entgegenhaltungen:
- DE-A1-102011 006 453
- DE-A1-102012 210 374
- US-A1- 2013 104 651

## Beschreibung

### Stand der Technik

Die Erfindung geht aus von einem Drehratensensor nach dem Oberbegriff des Anspruchs 1.

Ein derartiger Drehratensensor ist beispielsweise aus der DE 10 2011 006 394 A1 bekannt. Die erste und zweite Struktur eines solchen Drehratensensors führen bei der gegenphasigen Schwingung jeweils eine Pendelbewegung, bzw. eine 2f-Bewegung, orthogonal zu der Antriebsrichtung, d.h. orthogonal zu der ersten Achse, aus. Hierdurch wird ein Detektionssignal, bzw. ein 2f-Signal, beim zweifachen der Antriebsfrequenz verursacht.

### Offenbarung der Erfindung

Der erfindungsgemäße Drehratensensor hat gegenüber dem Stand der Technik den Vorteil, dass der erfindungsgemäße Drehratensensor gezielt eine Reduzierung der 2f-Bewegung und somit eine Reduzierung des 2f-Signals ermöglicht ohne die restlichen Sensoreigenschaften negativ zu beeinflussen. Aus DE10 2012 210374 A1, DE10 2011 006453 A1 und US2013/104651 A1 sind Drehratensensoren bekannt, welche eine solche Reduzierung erreichen. Gleichzeitig weist der erfindungsgemäße Drehratensensor einen im Vergleich zum Stand der Technik einfachen, mechanisch robusten und kostengünstigen Aufbau auf. Des Weiteren wird der Drehratensensor auf einer relativ zum Stand der Technik geringen Substratfläche ermöglicht, da für die mikromechanische Struktur lediglich eine relativ zum Stand der Technik geringe Substratfläche zur Detektion von Drehraten benötigt wird. Ferner wird ein gegenüber äußeren Störeinflüssen robuster Drehratensensor bereitgestellt. Dies wird dadurch erreicht, dass die erste Antriebsstruktur mindestens eine an dem Substrat befestigte erste Feder derart aufweist, dass die erste Feder einem Verschwenken der ersten Struktur im Wesentlichen um eine zu einer senkrecht zu der Haupterstreckungsebene verlaufenden zweiten Achse parallel verlaufende Achse entgegenwirkt, wobei die zweite Antriebsstruktur mindestens eine an dem Substrat befestigte zweite Feder derart aufweist, dass die zweite Feder einem Verschwenken der zweiten Struktur im Wesentlichen um eine zu der zweiten Achse parallel verlaufende weitere Achse entgegenwirkt. Hierdurch kann mithilfe der ersten Feder und/oder der zweiten Feder die mechanische Nichtlinearität des Drehratensensors gezielt eingestellt werden und somit kann die 2f-Bewegung sowie das 2f Signal reduziert werden.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer bevorzugten Weiterbildung ist vorgesehen, dass der Drehratensensor mindestens eine dritte Antriebsstruktur zur Auslenkung der ersten Struktur aus einer Ruhelage der ersten Struktur mit einer Bewegungskomponente im Wesentlichen parallel zu der ersten Achse umfasst, wobei die dritte Antriebsstruktur mindestens eine an dem Substrat befestigte dritte Feder derart aufweist, dass die dritte Feder einem Verschwenken der ersten Struktur im Wesentlichen um die zu der zweiten Achse parallel verlaufende Achse entgegenwirkt. Hierdurch wird auf vorteilhafte Weise ein Drehratensensor vorgeschlagen, dessen Nichtlinearität mithilfe der dritten Feder gezielt eingestellt werden kann und dessen 2f-Bewegung sowie das durch die 2f-Bewegung erzeugte 2f-Signal somit gezielt reduziert werden kann.

Gemäß einer bevorzugten Weiterbildung ist vorgesehen, dass der Drehratensensor mindestens eine vierte Antriebsstruktur zur Auslenkung der zweiten Struktur aus einer Ruhelage der zweiten Struktur mit einer Bewegungskomponente im Wesentlichen parallel zu der ersten Achse umfasst, wobei die vierte Antriebsstruktur mindestens eine an dem Substrat befestigte vierte Feder derart aufweist, dass die vierte Feder einem Verschwenken der zweiten Struktur im Wesentlichen um die zu der zweiten Achse parallel verlaufende weitere Achse entgegenwirkt. Hierdurch wird vorteilhaft ermöglicht, dass die Nichtlinearität mithilfe der vierten Feder gezielt eingestellt werden kann und somit die 2f-Bewegung sowie das durch die 2f-Bewegung erzeugte 2f-Signal gezielt reduziert werden kann.

Gemäß einer bevorzugten Weiterbildung ist vorgesehen, dass der Drehratensensor eine erste Koppelstruktur zum Koppeln der ersten Antriebsstruktur mit der zweiten Antriebsstruktur derart umfasst, dass die erste Antriebsstruktur und die zweite Antriebsstruktur zu einer im Wesentlichen gegenphasige Schwingung mit Bewegungskomponenten im Wesentlichen parallel zu der ersten Achse auslenkbar sind. Hierdurch wird vorteilhaft ermöglicht, dass die erste Struktur und die zweite Struktur zu einer im Wesentlichen gegenphasigen Schwingung mit Bewegungskomponenten im Wesentlichen parallel zu der ersten Achse anregbar sind.

Gemäß einer bevorzugten Weiterbildung ist vorgesehen, dass der Drehratensensor eine zweite Koppelstruktur zum Koppeln der dritten Antriebsstruktur mit der vierten Antriebsstruktur derart umfasst, dass die dritte Antriebsstruktur und die vierte Antriebsstruktur zu einer im Wesentlichen gegenphasige Schwingung mit Bewegungskomponenten im Wesentlichen parallel zu der ersten Achse auslenkbar sind. In vorteilhafter Weise wird somit ein Anregen der ersten Struktur und der zweiten Struktur zu einer im Wesentlichen gegenphasigen Schwingung mit Bewegungskomponenten im Wesentlichen parallel zu der ersten Achse ermöglicht.

Gemäß einer bevorzugten Weiterbildung ist vorgesehen, dass der Drehratensensor eine von der ersten Struktur und von der zweiten Struktur teilweise umgebene dritte Koppelstruktur zum Koppeln der ersten Struktur mit der zweiten Struktur derart umfasst, dass die erste Struktur und die zweite Struktur zu einer im Wesentlichen gegenphasigen Schwingung mit einer Bewegungskomponente im Wesentlichen parallel zu der ersten Achse und/oder mit einer Bewegungskomponente im Wesentlichen parallel zu einer senkrecht zu der ersten Achse und senkrecht zu der zweiten Achse verlaufenden dritten Achse auslenkbar sind. Hierdurch wird vorteilhaft ermöglicht, dass eine um eine parallel zu der zweiten Achse verlaufende Achse auf den Drehratensensor wirkende Drehrate detektierbar ist. Ferner wird hierdurch vorteilhaft ermöglicht, dass der Drehratensensor auf einer relativ zum Stand der Technik geringen Substratfläche bereitgestellt wird und dass der Schwerpunkt der ersten Struktur und der Schwerpunkt der zweiten Struktur im Gegensatz zum Stand der Technik näher an der Symmetrieachse des Drehratensensors angeordnet ist. Hierdurch wird ein besonders gegenüber beispielsweise in Antriebsrichtung wirkende äußere Störungen wie beispielsweise Linearbeschleunigungen robuster Drehratensensor bereitgestellt. Eine derartige Ausgestaltung ist vorteilhaft für die Robustheit gegen Linearbeschleunigungen in Antriebsrichtung, da bei zentraleren Massenschwerpunkten die Hebelverhältnisse günstiger sind und dadurch die Auslenkung des Sensors bei äußerer Linearbeschleunigung in Antriebsrichtung reduziert wird.

Gemäß einer bevorzugten Weiterbildung ist vorgesehen, dass die erste Struktur eine erste Coriolisstruktur sowie eine von der ersten Coriolisstruktur zumindest teilweise umgebene erste Detektionsstruktur zum Detektieren einer ersten Kraftwirkung auf die erste Struktur und die zweite Struktur eine zweite Coriolisstruktur sowie eine von der zweiten Coriolisstruktur zumindest teilweise umgebene zweite Detektionsstruktur zum Detektieren einer zweiten Kraftwirkung auf die zweite Struktur umfassen, wobei die erste Kraftwirkung und die zweite Kraftwirkung jeweils eine Kraftkomponente entlang einer Richtung im Wesentlichen parallel zu einer senkrecht zu der ersten Achse und senkrecht zu der zweiten Achse verlaufenden dritten Achse aufgrund einer Drehrate des Drehratensensors um eine Achse im Wesentlichen parallel zu der zweiten Achse umfassen. Hierdurch wird vorteilhaft ermöglicht, dass eine Drehrate des Drehratensensors um die Achse im Wesentlichen parallel zu der zweiten Achse von dem Drehratensensor detektierbar ist.

Erfindungsgemäss ist vorgesehen, dass die erste Feder und/oder die zweite Feder und in einer bevorzugten Weiterbildung die dritte Feder und/oder die vierte Feder mindestens einen substratfesten ersten Federbalken, mindestens einen substratfesten zweiten Federbalken, mindestens einen den ersten Federbalken und den zweiten Federbalken verbindenden biegesteifen Balken, mindestens einen den biegesteifen Balken und die jeweilige Antriebsstruktur verbindenden dritten Federbalken und mindestens einen den biegesteifen Balken und die jeweilige Antriebsstruktur verbindenden vierten Federbalken umfasst. Auf vorteilhafte Weise wird somit mithilfe des ersten Federbalkens und/oder des zweiten Federbalkens und/oder des dritten Federbalkens und/oder des vierten Federbalkens und/oder des Balkens ein gezieltes Einstellen der mechanischen Nichtlinearität des Drehratensensors und somit ein Reduzieren der 2f-Bewegung sowie des 2f-Signals ermöglicht. Insbesondere kann somit auf vorteilhafte Weise der 2f-Bewegung durch gezieltes Einstellen der Geometrieparameter, insbesondere der Breiten- und Längenverhältnisse des ersten Federbalkens und/oder des zweiten Federbalkens und/oder des dritten Federbalkens und/oder des vierten Federbalkens durch eine kompensierende 2f-Kraft der ersten Feder und/oder der zweiten Feder und/oder der dritten Feder und/oder der vierten Feder entgegengewirkt werden. Hierdurch wird auf vorteilhafte Weise die 2f-Bewegung minimiert. Des Weiteren kann auf vorteilhafte Weise die Federhärte der ersten Feder und/oder der zweiten Feder und/oder der dritten Feder und/oder der vierten Feder und/oder des Balkens mithilfe der Längen und Breiten des ersten Federbalkens und/oder des zweiten Federbalkens und/oder des dritten Federbalkens und/oder des vierten Federbalkens und/oder des Balkens eingestellt werden. Hierdurch ist auf vorteilhafte Weise eine Einstellung der kompensierenden 2f-Kraft unabhängig von der Einstellung der Federhärte möglich.

### Kurze Beschreibung der Zeichnungen

**Figur 1** zeigt in einer schematischen Darstellung einen Drehratensensor gemäß einer ersten beispielhaften Ausführungsform der vorliegenden Erfindung.
**Figur 2** zeigt in einer schematischen Darstellung einen Drehratensensor gemäß einer zweiten beispielhaften Ausführungsform der vorliegenden Erfindung.
**Figur 3** zeigt in einer schematischen Darstellung beispielhafte Teilbereiche eines Drehratensensors gemäß weiterer beispielhafter Ausführungsformen der vorliegenden Erfindung.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

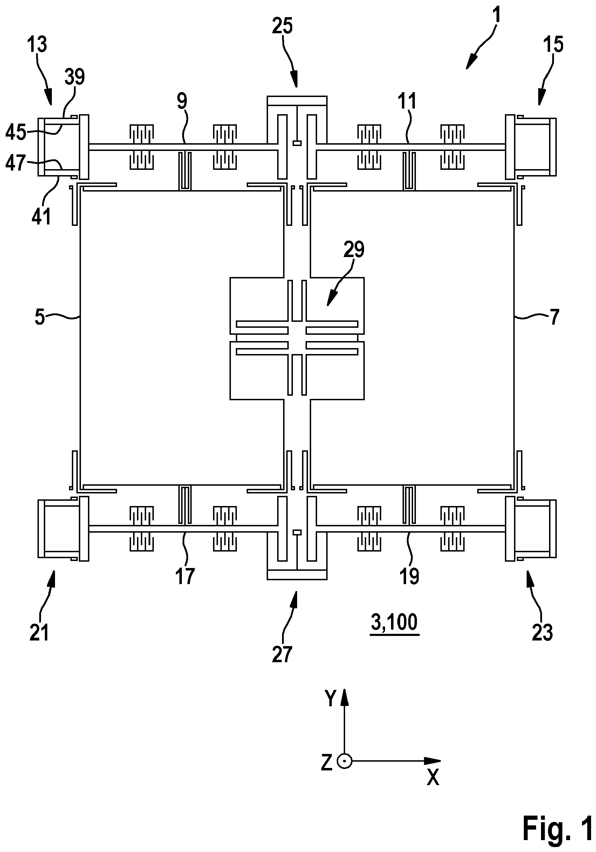

In **Figur 1** ist eine schematische Darstellung eines Drehratensensors 1 gemäß einer ersten beispielhaften Ausführungsform der vorliegenden Erfindung dargestellt, wobei der Drehratensensor 1 ein Substrat 3 mit einer Haupterstreckungsebene 100 und eine gegenüber dem Substrat 3 bewegliche erste Struktur 5 und eine gegenüber dem Substrat 3 und gegenüber der ersten Struktur 5 bewegliche zweite Struktur 7 umfasst. Ferner umfasst der Drehratensensor 1 in **Figur 1** beispielhaft eine erste Antriebsstruktur 9 und eine dritte Antriebsstruktur 17 zur Auslenkung der ersten Struktur 5 aus einer in **Figur 1** dargestellten Ruhelage der ersten Struktur 5 mit einer Bewegungskomponente im Wesentlichen parallel zu einer ersten Achse Y. Des Weiteren umfasst der Drehratensensor 1 in **Figur 1** beispielhaft eine zweite Antriebsstruktur 11 und eine vierte Antriebsstruktur 19 zur Auslenkung der zweiten Struktur 7 aus einer in **Figur 1** dargestellten Ruhelage der zweiten Struktur 7 mit einer Bewegungskomponente im Wesentlichen parallel zu der ersten Achse Y. Hierdurch sind die erste Struktur 5 und die zweite Struktur 7 zu einer im Wesentlichen gegenphasigen Schwingung mit Bewegungskomponenten im Wesentlichen parallel zu der ersten Achse Y anregbar.

In **Figur 1** ist auch beispielhaft dargestellt, dass die erste Antriebsstruktur 9 und die dritte Antriebsstruktur 17 eine an dem Substrat 3 befestigte erste Feder 13 bzw. dritte Feder 21 derart aufweist, dass die erste Feder 13 und die dritte Feder 21 einem Verschwenken der ersten Struktur 5 im Wesentlichen um eine zu einer zweiten Achse Z parallel verlaufende Achse entgegenwirkt. Vergleichbar stellt **Figur 1** dar, dass die zweite Antriebsstruktur 11 und die vierte Antriebsstruktur 19 eine an dem Substrat 3 befestigte zweite Feder 15 bzw. vierte Feder 23 derart aufweist, dass die zweite Feder 15 und die vierte Feder 23 einem Verschwenken der zweiten Struktur 7 im Wesentlichen um eine zu der zweiten Achse Z parallel verlaufende weitere Achse entgegenwirkt.

Des Weiteren umfasst der in **Figur 1** beispielhaft dargestellte Drehratensensor eine erste Koppelstruktur 25 zum Koppeln der ersten Antriebsstruktur 9 mit der zweiten Antriebsstruktur 11 und eine zweite Koppelstruktur 27 zum Koppeln der dritten Antriebsstruktur 17 mit der vierten Antriebsstruktur 19 derart, dass die erste Antriebsstruktur 9 und die zweite Antriebsstruktur 11 bzw. die dritte Antriebsstruktur 17 und die vierte Antriebsstruktur 19 zu jeweils einer im Wesentlichen gegenphasigen Schwingung mit Bewegungskomponenten im Wesentlichen parallel zu der ersten Achse Y auslenkbar sind. Zusätzlich zeigt **Figur 1** eine von der ersten Struktur 5 und von der zweiten Struktur 7 zumindest teilweise umgebene dritte Koppelstruktur 29 zum Koppeln der ersten Struktur 5 mit der zweiten Struktur 7. Die dritte Koppelstruktur 29 ermöglicht, dass die erste Struktur 5 und die zweite Struktur 7 zu einer im Wesentlichen gegenphasigen Schwingung mit Bewegungskomponenten im Wesentlichen parallel zu der ersten Achse Y und/oder mit einer Bewegungskomponente im Wesentlichen parallel zu einer dritten Achse X auslenkbar sind.

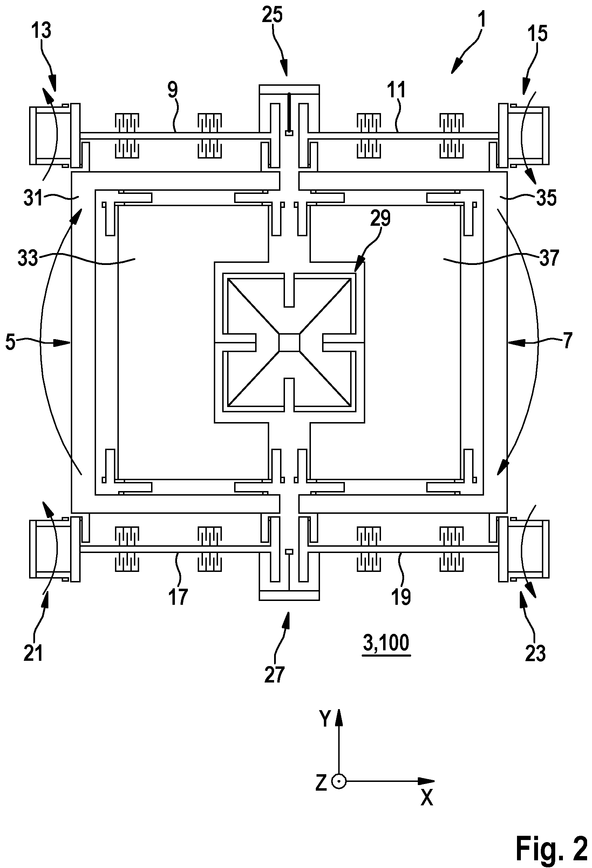

In **Figur 2** ist eine schematische Darstellung eines Drehratensensors 1 gemäß einer zweiten beispielhaften Ausführungsform der vorliegenden Erfindung dargestellt, wobei die erste Struktur 5 eine erste Coriolisstruktur 31 sowie eine von der ersten Coriolisstruktur 31 zumindest teilweise umgebene erste Detektionsstruktur 33 zum Detektieren einer ersten Kraftwirkung auf die erste Struktur 5 umfasst. Ferner umfasst die zweite Struktur 7 eine zweite Coriolisstruktur 35 sowie eine von der zweiten Coriolisstruktur 35 zumindest teilweise umgebene zweite Detektionsstruktur 37 zum Detektieren einer zweiten Kraftwirkung auf die zweite Struktur 7. Hierbei umfasst die erste Kraftwirkung und die zweite Kraftwirkung jeweils eine Kraftkomponente entlang einer Richtung im Wesentlichen parallel zu einer dritten Achse X aufgrund einer Drehrate des Drehratensensors 1 um eine Achse im Wesentlichen parallel zu der zweiten Achse Z. Die in **Figur 2** dargestellte dritte Koppelstruktur 29 ermöglicht beispielsweise, dass die erste Detektionsstruktur 33 und die zweite Detektionsstruktur 37 zu einer im Wesentlichen gegenphasigen Schwingung mit Bewegungskomponenten im Wesentlichen parallel zu der dritten Achse X auslenkbar sind.

Des Weiteren wird in **Figur 2** mithilfe von Pfeilen im Bereich der ersten Coriolisstruktur 31 und im Bereich der zweiten Coriolisstruktur 35 eine mögliche 2f-Bewegung der ersten Struktur 5 und der zweiten Struktur 7 dargestellt. Die 2f-Bewegung geht sowohl bei der Aufwärts- wie auch bei der Abwärtsbewegung, d.h. sowohl bei der Hin- wie auch bei der Her-Schwenkbewegung, in die gleiche Richtung. Die Coriolisstrukturen 31, 35 führen also eine leichte Pendelbewegung (2f-Bewegung) aus. Diese Bewegung, seitwärts zu der Antriebsrichtung, wird auf die Detektionsstrukturen 33, 37 übertragen und führt zu einem Detektionssignal bei der doppelten Antriebsfrequenz. Zusätzlich wird in **Figur 2** mithilfe von weiteren Pfeilen im Bereich der ersten Feder 13, der zweiten Feder 15, der dritten Feder 21 und der vierten Feder 23 eine kompensierende 2f-Kraft, welche der möglichen 2f-Bewegung entgegen wirkt dargestellt.

Die in **Figur 1** und **Figur 2** dargestellten Ausführungsbeispiele umfassen jeweils die Antriebsstrukturen 9, 11, 17, 19 und die Federn 13, 15, 21, 23. Bevorzugt ist jedoch auch beispielsweise ein Drehratensensor mit nur der ersten Antriebsstruktur 9 und der ersten Feder 13 oder mit jeder beliebigen Anzahl an Antriebsstrukturen 9, 11, 17, 19 und Federn 13,15, 21, 23, insbesondere einer Anzahl an Antriebsstrukturen und/oder Federn von 3, 5, 6, 7, 8, 9, 10, 11, 12, 13, 14, 15, 16 vorgesehen.

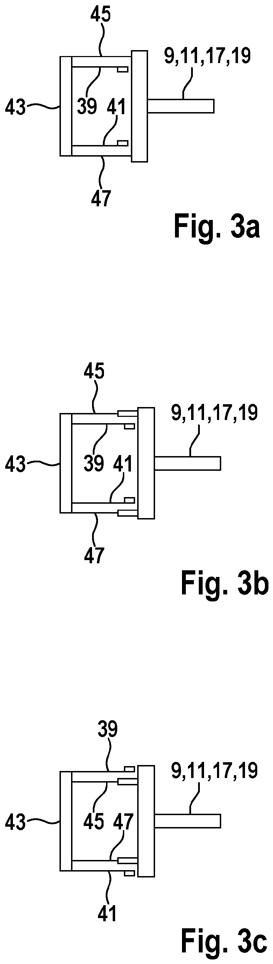

In **Figur 3a, 3b, 3c** sind schematische Darstellungen eines beispielhaften Teilbereichs eines Drehratensensors 1 gemäß weiterer beispielhafter Ausführungsformen der vorliegenden Erfindung dargestellt, wobei die erste Feder 13 und/oder die zweite Feder 15 und/oder die dritte Feder 21 und/oder die vierte Feder 23 einen substratfesten ersten Federbalken 39, einen substratfesten zweiten Federbalken 41, einen den ersten Federbalken 39 und den zweiten Federbalken 41 verbindenden biegesteifen Balken 43, einen den biegesteifen Balken 43 und die jeweilige Antriebsstruktur 9, 11, 17, 19 verbindenden dritten Federbalken 45 und einen den biegesteifen Balken 43 und die jeweilige Antriebsstruktur 9, 11, 17, 19 verbindenden vierten Federbalken 47 umfasst.

**Figur 3a** zeigt schematisch eine erste Ausführungsform der Feder 13, 15, 21, 23, wobei die Feder 13, 15, 21, 23 kurze innere Federbalken 39, 41 umfasst. **Figur 3b** zeigt schematisch eine zweite Ausführungsform der Feder 13, 15, 21, 23, wobei die Feder 13, 15, 21, 23 effektiv verkürzte äußere Federbalken 45, 47 umfasst, was zu einer invertieren Nichtlinearität führt. **Figur 3c** zeigt schematisch eine dritte Ausführungsform der Feder 13, 15, 21, 23, wobei die Feder 13, 15, 21, 23 substratfeste äußere Federbalken 39, 41 und innere Federbalken 45, 47 umfasst.

Hierdurch können beispielsweise über die Breiten- und Längenverhältnisse der Federbalken die 2f-Kräfte der Federn 13, 15, 21, 23 eingestellt werden. Somit können die Federn 13, 15, 21, 23 so angepasst werden, dass die Federn den 2f-Kräften des restlichen Sensors entgegenwirken und die resultierende 2f-Bewegung minimieren. Hierbei bietet die Aufhängung der Antriebsstrukturen 9, 11, 17, 19 an den Federn 13, 15, 21, 23 den Vorteil, dass sich die mechanischen Nichtlinearitäten der Federn 13, 15, 21, 23 über deren Geometrieparameter so einstellen lassen, dass die 2f-Kräfte des Sensorelements durch die Nichtlinearitäten der Federn 13, 15, 21, 23 kompensiert werden. Sowohl der Betrag als auch die Richtung der 2f-Kräfte der Federn 13, 15, 21, 23 können über die Breiten- und Längenverhältnisse der äußeren und inneren Federbalken 39, 41, 45, 47 variiert werden. Durch eine Invertierung der Längenverhältnisse der Federbalken 39, 41, 45, 47 (**Figur 3a** und **Figur 3b**) kann beispielsweise die Richtung der resultierenden 2f-Kraft der Federn 13, 15, 21, 23 invertiert werden. Die Federhärte kann über die absoluten Längen und Breiten der einzelnen Federbalken 39, 41, 45, 47 kontrolliert werden, sodass Federhärte und 2f-Kraft unabhängig voneinander eingestellt werden können.

Außerdem bieten die Federn 13, 15, 21, 23 den Vorteil, dass sie sehr hart gegenüber Kippbewegungen sind. D.h. der der jeweiligen Antriebsstruktur 9, 11, 17, 19 zugehörige Balken, welcher an einer der Federn 13, 15, 21, 23 aufgehängt ist, schwingt in der Grundmode parallel zur Balkenverbindung der Federköpfe und mögliche Drehbewegungen werden zu sehr hohen Frequenzen geschoben.

## Patentansprüche

1. Drehratensensor (1) mit einem Substrat (3) mit einer Haupterstreckungsebene (100) und mit mindestens einer gegenüber dem Substrat (3) beweglichen ersten Struktur (5) und mit mindestens einer gegenüber dem Substrat (3) und gegenüber der ersten Struktur (5) beweglichen zweiten Struktur (7), wobei der Drehratensensor (1) mindestens eine erste Antriebsstruktur (9) zur Auslenkung der ersten Struktur (5) aus einer Ruhelage der ersten Struktur (5) mit einer Bewegungskomponente im Wesentlichen parallel zu einer ersten Achse (Y) umfasst, wobei der Drehratensensor (1) mindestens eine zweite Antriebsstruktur (11) zur Auslenkung der zweiten Struktur (7) aus einer Ruhelage der zweiten Struktur (7) mit einer Bewegungskomponente im Wesentlichen parallel zu der ersten Achse (Y) umfasst, wobei die erste Struktur (5) und die zweite Struktur (7) zu einer im Wesentlichen gegenphasigen Schwingung mit Bewegungskomponenten im Wesentlichen parallel zu der ersten Achse (Y) anregbar sind, wobei die erste Antriebsstruktur (9) mindestens eine an dem Substrat (3) befestigte erste Feder (13) derart aufweist, dass die erste Feder (13) einem Verschwenken der ersten Struktur (5) im Wesentlichen um eine zu einer senkrecht zu der Haupterstreckungsebene (100) verlaufenden zweiten Achse (Z) parallel verlaufende Achse entgegenwirkt, wobei die zweite Antriebsstruktur (11) mindestens eine an dem Substrat (3) befestigte zweite Feder (15) derart aufweist, dass die zweite Feder (15) einem Verschwenken der zweiten Struktur (7) im Wesentlichen um eine zu der zweiten Achse (Z) parallel verlaufende weitere Achse entgegenwirkt, **dadurch gekennzeichnet, dass** die erste Feder (13) und/oder die zweite Feder (15) mindestens einen substratfesten ersten Federbalken (39), mindestens einen substratfesten zweiten Federbalken (41), mindestens einen den ersten Federbalken (39) und den zweiten Federbalken (41) verbindenden biegesteifen Balken (43), mindestens einen den biegesteifen Balken (43) und die jeweilige Antriebsstruktur (9, 11) verbindenden dritten Federbalken (45) und mindestens einen den biegesteifen Balken (43) und die jeweilige Antriebsstruktur (9, 11) verbindenden vierten Federbalken (47) umfasst.

2. Drehratensensor (1) nach Anspruch 1, **dadurch gekennzeichnet, dass** der Drehratensensor (1) mindestens eine dritte Antriebsstruktur (17) zur Auslenkung der ersten Struktur (5) aus einer Ruhelage der ersten Struktur (5) mit einer Bewegungskomponente im Wesentlichen parallel zu der ersten Achse (Y) umfasst, wobei die dritte Antriebsstruktur (17) mindestens eine an dem Substrat (3) befestigte dritte Feder (21) derart aufweist, dass die dritte Feder (21) einem Verschwenken der ersten Struktur (5) im Wesentlichen um die zu der zweiten Achse (Z) parallel verlaufende Achse entgegenwirkt.

3. Drehratensensor (1) nach einem der vorhergehenden Ansprüche, **dadurch gekennzeichnet, dass** der Drehratensensor (1) mindestens eine vierte Antriebsstruktur (19) zur Auslenkung der zweiten Struktur (7) aus einer Ruhelage der zweiten Struktur (7) mit einer Bewegungskomponente im Wesentlichen parallel zu der ersten Achse (Y) umfasst, wobei die vierte Antriebsstruktur (19) mindestens eine an dem Substrat (3) befestigte vierte Feder (23) derart aufweist, dass die vierte Feder (23) einem Verschwenken der zweiten Struktur (7) im Wesentlichen um die zu der zweiten Achse (Z) parallel verlaufende weitere Achse entgegenwirkt.

4. Drehratensensor (1) nach einem der vorhergehenden Ansprüche, **dadurch gekennzeichnet, dass** der Drehratensensor (1) eine erste Koppelstruktur (25) zum Koppeln der ersten Antriebsstruktur (9) mit der zweiten Antriebsstruktur (11) derart umfasst, dass die erste Antriebsstruktur (9) und die zweite Antriebsstruktur (11) zu einer im Wesentlichen gegenphasige Schwingung mit Bewegungskomponenten im Wesentlichen parallel zu der ersten Achse (Y) auslenkbar sind.

5. Drehratensensor (1) nach einem der vorhergehenden Ansprüche, **dadurch gekennzeichnet, dass** der Drehratensensor (1) eine zweite Koppelstruktur (27) zum Koppeln der dritten Antriebsstruktur (17) mit der vierten Antriebsstruktur (19) derart umfasst, dass die dritte Antriebsstruktur (17) und die vierte Antriebsstruktur (19) zu einer im Wesentlichen gegenphasige Schwingung mit Bewegungskomponenten im Wesentlichen parallel zu der ersten Achse (Y) auslenkbar sind.

6. Drehratensensor (1) nach einem der vorhergehenden Ansprüche, **dadurch gekennzeichnet, dass** der Drehratensensor (1) eine von der ersten Struktur (5) und von der zweiten Struktur (7) teilweise umgebene dritte Koppelstruktur (29) zum Koppeln der ersten Struktur (5) mit der zweiten Struktur (7) derart umfasst, dass die erste Struktur (5) und die zweite Struktur (7) zu einer im Wesentlichen gegenphasigen Schwingung mit einer Bewegungskomponente im Wesentlichen parallel zu der ersten Achse (Y) und/oder mit einer Bewegungskomponente im Wesentlichen parallel zu einer senkrecht zu der ersten Achse (Y) und senkrecht zu der zweiten Achse (Z) verlaufenden dritten Achse (X) auslenkbar sind.

7. Drehratensensor (1) nach einem der vorhergehenden Ansprüche, **dadurch gekennzeichnet, dass** die erste Struktur (5) eine erste Coriolisstruktur (31) sowie eine von der ersten Coriolisstruktur (31) zumindest teilweise umgebene erste Detektionsstruktur (33) zum Detektieren einer ersten Kraftwirkung auf die erste Struktur (5) und die zweite Struktur (7) eine zweite Coriolisstruktur (35) sowie eine von der zweiten Coriolisstruktur (35) zumindest teilweise umgebene zweite Detektionsstruktur (37) zum Detektieren einer zweiten Kraftwirkung auf die zweite Struktur (7) umfassen, wobei die erste Kraftwirkung und die zweite Kraftwirkung jeweils eine Kraftkomponente entlang einer Richtung im Wesentlichen parallel zu einer senkrecht zu der ersten Achse (Y) und senkrecht zu der zweiten Achse (Z) verlaufenden dritten Achse (X) aufgrund einer Drehrate des Drehratensensors (1) um eine Achse im Wesentlichen parallel zu der zweiten Achse (Z) umfassen.

8. Drehratensensor (1) nach einem der Ansprüche 2 bis 7, **dadurch gekennzeichnet, dass** die dritte Feder (21) und/oder die vierte Feder (23) mindestens einen substratfesten ersten Federbalken (39), mindestens einen substratfesten zweiten Federbalken (41), mindestens einen den ersten Federbalken (39) und den zweiten Federbalken (41) verbindenden biegesteifen Balken (43), mindestens einen den biegesteifen Balken (43) und die jeweilige Antriebsstruktur (17, 19) verbindenden dritten Federbalken (45) und mindestens einen den biegesteifen Balken (43) und die jeweilige Antriebsstruktur (17, 19) verbindenden vierten Federbalken (47) umfasst.

## Claims

1. Rotation rate sensor (1) with a substrate (3) with a main plane of extent (100) and with at least a first structure (5) movable with respect to the substrate (3) and with at least a second structure (7) movable with respect to the substrate (3) and with respect to the first structure (5), wherein the rotation rate sensor (1) comprises at least a first drive structure (9) for deflecting the first structure (5) out of a rest position of the first structure (5) with a movement component substantially parallel to a first axis (Y), wherein the rotation rate sensor (1) comprises at least a second drive structure (11) for deflecting the second structure (7) out of a rest position of the second structure (7) with a movement component substantially parallel to the first axis (Y), wherein the first structure (5) and the second structure (7) can be excited to oscillate substantially in counter-phase with movement components substantially parallel to the first axis (Y), wherein the first drive structure (9) has at least a first spring (13) fastened to the substrate (3) in such a way that the first spring (13) counteracts pivoting of the first structure (5) substantially about an axis extending parallel to a second axis (Z) extending perpendicular to the main plane of extent (100), wherein the second drive structure (11) has at least a second spring (15) fastened to the substrate (3) in such a way that the second spring (15) counteracts pivoting of the second structure (7) substantially about a further axis extending parallel to the second axis (Z), **characterized in that** the first spring (13) and/or the second spring (15) comprise/comprises at least a substrate-mounted first spring beam (39), at least a substrate-mounted second spring beam (41), at least a flexurally rigid beam (43) connecting the first spring beam (39) and the second spring beam (41), at least a third spring beam (45) connecting the flexurally rigid beam (43) and the respective drive structure (9, 11), and at least a fourth spring beam (47) connecting the flexurally rigid beam (43) and the respective drive structure (9, 11).

2. Rotation rate sensor (1) according to Claim 1, **characterized in that** the rotation rate sensor (1) comprises at least a third drive structure (17) for deflecting the first structure (5) out of a rest position of the first structure (5) with a movement component substantially parallel to the first axis (Y), wherein the third drive structure (17) has at least a third spring (21) fastened to the substrate (3) in such a way that the third spring (21) counteracts pivoting of the first structure (5) substantially about the axis extending parallel to the second axis (Z).

3. Rotation rate sensor (1) according to either of the preceding claims, **characterized in that** the rotation rate sensor (1) comprises at least a fourth drive structure (19) for deflecting the second structure (7) out of a rest position of the second structure (7) with a movement component substantially parallel to the first axis (Y), wherein the fourth drive structure (19) has at least a fourth spring (23) fastened to the substrate (3) in such a way that the fourth spring (23) counteracts pivoting of the second structure (7) substantially about the further axis extending parallel to the second axis (Z).

4. Rotation rate sensor (1) according to one of the preceding claims, **characterized in that** the rotation rate sensor (1) comprises a first coupling structure (25) for coupling the first drive structure (9) to the second drive structure (11) in such a way that the first drive structure (9) and the second drive structure (11) can be deflected to oscillate substantially in counter-phase with movement components substantially parallel to the first axis (Y).

5. Rotation rate sensor (1) according to one of the preceding claims, **characterized in that** the rotation rate sensor (1) comprises a second coupling structure (27) for coupling the third drive structure (17) to the fourth drive structure (19) in such a way that the third drive structure (17) and the fourth drive structure (19) can be deflected to oscillate substantially in counter-phase with movement components substantially parallel to the first axis (Y).

6. Rotation rate sensor (1) according to one of the preceding claims, **characterized in that** the rotation rate sensor (1) comprises a third coupling structure (29) which is partially surrounded by the first structure (5) and by the second structure (7) and intended for coupling the first structure (5) to the second structure (7) in such a way that the first structure (5) and the second structure (7) can be deflected to oscillate substantially in counter-phase with a movement component substantially parallel to the first axis (Y) and/or with a movement component substantially parallel to a third axis (X) extending perpendicular to the first axis (Y) and perpendicular to the second axis (Z).

7. Rotation rate sensor (1) according to one of the preceding claims, **characterized in that** the first structure (5) comprises a first Coriolis structure (31) and a first detection structure (33) which is at least partially surrounded by the first Coriolis structure (31) and intended for detecting a first action of force on the first structure (5), and the second structure (7) comprises a second Coriolis structure (35) and a second detection structure (37) which is at least partially surrounded by the second Coriolis structure (35) and intended for detecting a second action of force on the second structure (7), wherein the first action of force and the second action of force each comprise a force component along a direction substantially parallel to a third axis (X) extending perpendicular to the first axis (Y) and perpendicular to the second axis (Z) as a result of a rotation rate of the rotation rate sensor (1) about an axis substantially parallel to the second axis (Z).

8. Rotation rate sensor (1) according to one of Claims 2 to 7, **characterized in that** the third spring (21) and/or the fourth spring (23) comprise/comprises at least a substrate-mounted first spring beam (39), at least a substrate-mounted second spring beam (41), at least a flexurally rigid beam (43) connecting the first spring beam (39) and the second spring beam (41), at least a third spring beam (45) connecting the flexurally rigid beam (43) and the respective drive structure (17, 19), and at least a fourth spring beam (47) connecting the flexurally rigid beam (43) and the respective drive structure (17, 19) .

## Revendications

1. Capteur de vitesse de rotation (1), comprenant un substrat (3) ayant un plan de projection principal (100) et comprenant au moins une première structure (5) mobile par rapport au substrat (3) et comprenant au moins une deuxième structure (7) mobile par rapport au substrat (3) et par rapport à la première structure (5), le capteur de vitesse de rotation (1) comportant au moins une première structure d'entraînement (9) destinée à dévier la première structure (5) hors d'une position de repos de la première structure (5) avec une composante de mouvement sensiblement parallèle à un premier axe (Y), le capteur de vitesse de rotation (1) comportant au moins une deuxième structure d'entraînement (11) destinée à dévier la deuxième structure (7) hors d'une position de repos de la deuxième structure (7) avec une composante de mouvement sensiblement parallèle au premier axe (Y), la première structure (5) et la deuxième structure (7) pouvant être excitées en une oscillation sensiblement en opposition de phase avec des composantes de mouvement sensiblement parallèles au premier axe (Y), la première structure d'entraînement (9) possédant au moins un premier ressort (13) fixé au substrat (3) de telle sorte que le premier ressort (13) s'oppose à un pivotement de la première structure (5) sensiblement autour d'un axe qui s'étend parallèlement à un deuxième axe (Z) qui s'étend perpendiculairement au plan de projection principal (100), la deuxième structure d'entraînement (11) possédant au moins un deuxième ressort (15) fixé au substrat (3) de telle sorte que le deuxième ressort (15) s'oppose à un pivotement de la deuxième structure (7) sensiblement autour d'un axe supplémentaire qui s'étend parallèlement au deuxième axe (Z), **caractérisé en ce que** le premier ressort (13) et/ou le deuxième ressort (15) comporte au moins une première barre de ressort (39) fixe sur le substrat, au moins une deuxième barre de ressort (41) fixe sur le substrat, au moins une barre (43) rigide en flexion qui relie la première barre de ressort (39) et la deuxième barre de ressort (41), au moins une troisième barre de ressort (45) qui relie la barre (43) rigide en flexion et la structure d'entraînement (9, 11) respective et au moins une quatrième barre de ressort (47) qui relie la barre (43) rigide en flexion et la structure d'entraînement (9, 11) respective.

2. Capteur de vitesse de rotation (1) selon la revendication 1, **caractérisé en ce que** le capteur de vitesse de rotation (1) comporte au moins une troisième structure d'entraînement (17) destinée à dévier la première structure (5) hors d'une position de repos de la première structure (5) avec une composante de mouvement sensiblement parallèle au premier axe (Y), la troisième structure d'entraînement (17) possédant au moins un troisième ressort (21) fixé au substrat (3) de telle sorte que le troisième ressort (21) s'oppose à un pivotement de la première structure (5) sensiblement autour de l'axe qui s'étend parallèlement au deuxième axe (Z) .

3. Capteur de vitesse de rotation (1) selon l'une des revendications précédentes, **caractérisé en ce que** le capteur de vitesse de rotation (1) comporte au moins une quatrième structure d'entraînement (19) destinée à dévier la deuxième structure (7) hors d'une position de repos de la deuxième structure (7) avec une composante de mouvement sensiblement parallèle au premier axe (Y), la quatrième structure d'entraînement (19) possédant au moins un quatrième ressort (23) fixé au substrat (3) de telle sorte que le quatrième ressort (23) s'oppose à un pivotement de la deuxième structure (7) sensiblement autour de l'axe supplémentaire qui s'étend parallèlement au deuxième axe (Z).

4. Capteur de vitesse de rotation (1) selon l'une des revendications précédentes, **caractérisé en ce que** le capteur de vitesse de rotation (1) comporte une première structure d'accouplement (25) destinée à accoupler la première structure d'entraînement (9) à la deuxième structure d'entraînement (11) de telle sorte que la première structure d'entraînement (9) et la deuxième structure d'entraînement (11) peuvent être déviées en une oscillation sensiblement en opposition de phase avec des composantes de mouvement sensiblement parallèles au premier axe (Y).

5. Capteur de vitesse de rotation (1) selon l'une des revendications précédentes, **caractérisé en ce que** le capteur de vitesse de rotation (1) comporte une deuxième structure d'accouplement (27) destinée à accoupler la troisième structure d'entraînement (17) à la quatrième structure d'entraînement (19) de telle sorte que la troisième structure d'entraînement (17) et la quatrième structure d'entraînement (19) peuvent être déviées en une oscillation sensiblement en opposition de phase avec des composantes de mouvement sensiblement parallèles au premier axe (Y).

6. Capteur de vitesse de rotation (1) selon l'une des revendications précédentes, **caractérisé en ce que** le capteur de vitesse de rotation (1) comporte une troisième structure d'accouplement (29), partiellement entourée par la première structure (5) et par la deuxième structure (7), destinée à accoupler la première structure (5) à la deuxième structure (7) de telle sorte que la première structure (5) et la deuxième structure (7) peuvent être déviées en une oscillation sensiblement en opposition de phase avec une composante de mouvement sensiblement parallèle au premier axe (Y) et/ou avec une composante de mouvement sensiblement parallèle à un troisième axe (X) qui s'étend perpendiculairement au premier axe (Y) et perpendiculairement au deuxième axe (Z) .

7. Capteur de vitesse de rotation (1) selon l'une des revendications précédentes, **caractérisé en ce que** la première structure (5) comporte une première structure à effet de Coriolis (31) ainsi qu'une première structure de détection (33), au moins partiellement entourée par la première structure à effet de Coriolis (31), destinée à détecter un premier effet dynamique sur la première structure (5) et la deuxième structure (7) comporte une deuxième structure à effet de Coriolis (35) ainsi qu'une deuxième structure de détection (37), au moins partiellement entourée par la deuxième structure à effet de Coriolis (35), destinée à détecter un deuxième effet dynamique sur la deuxième structure (7), le premier effet dynamique et le deuxième effet dynamique comprenant respectivement une composante de force le long d'une direction sensiblement parallèle à un troisième axe (X) qui s'étend perpendiculairement au premier axe (Y) et perpendiculairement au deuxième axe (Z) en raison d'une vitesse de rotation du capteur de vitesse de rotation (1) autour d'un axe sensiblement parallèle au deuxième axe (Z) .

8. Capteur de vitesse de rotation (1) selon l'une des revendications 2 à 7, **caractérisé en ce que** le troisième ressort (21) et/ou le quatrième ressort (23) comporte au moins une première barre de ressort (39) fixe sur le substrat, au moins une deuxième barre de ressort (41) fixe sur le substrat, au moins une barre (43) rigide en flexion qui relie la première barre de ressort (39) et la deuxième barre de ressort (41), au moins une troisième barre de ressort (45) qui relie la barre (43) rigide en flexion et la structure d'entraînement (17, 19) respective et au moins une quatrième barre de ressort (47) qui relie la barre (43) rigide en flexion et la structure d'entraînement (17, 19) respective.
